# EUROPEAN PATENT APPLICATION

(11) **EP 2 541 261 A1**
(43) Date of publication of application: **02.01.2013**
(21) Application number: 12173118.6
(22) Date of filing: 22.06.2012
(51) Int. Cl.: G01R 15/20

(54) **Device and procedure for current detection**

(30) Priority: 27.06.2011 BE 201100388
(71) Applicant: PsiControl Mechatronics, 8900 Leper (BE)
(72) Inventor: Servaes, Jan, 8570 Vichte (BE); Lagae, Koen, 8870 Izegem (BE); Faes, Ludo, 8970 Poperinge (BE)
(74) Representative: Patentanwälte Ruff, Wilhelm, Beier, Dauster & Partner

(57) **Abstract**

The invention relates to a device (10) for detecting a current in a conductor (25), the device (10) comprises a magnetic field sensor (28), such as a Hall sensor, and also a yoke (27) for conducting magnetic flux. This yoke (27) can be adjusted to the size of the conductor (25) in order to partially surround the conductor (25). The invention also relates to a vehicle comprising such a device (10). The invention also relates to a method for detecting a current in a conductor (25), wherein the yoke (27) deforms during surrounding the conductor (25).

## Description

### Technical Field

The invention relates to a device for detecting a current. The invention also relates to a vehicle provided with such a device and a method for mounting such a device.

### Prior art

A device for detecting a current, such as a current sensor based on a contactless detection of a current in a conductor, also referred to as a contactless current sensor, is known and is described, for example in EP 0 772 046 A2. Using a contactless current sensor, a current in a conductor, also referred to as a current conductor, is detected without influencing the current, for example without interrupting the conductor or without conducting the current through a sensor. Detection may be effected, for example, by means of a Hall sensor.

Where in the past, with a vehicle, the connection for the electrical connector of a trailer, also referred to as trailer vehicle, used to be a parallel branch on a conductor for the lighting of the vehicle, also referred to as tow vehicle, this is no longer readily possible with modern vehicles due to the electronic control of the lighting and additional systems for lamp failure detection. To this end, contactless sensors have been proposed, as described in EP 1498312 A1, US 2007/063689 A1 and WO 2009/072668 A1.

Using contactless sensors, the current is detected in a conductor for the lighting of the tow vehicle, and based on the signals obtained, the lighting of the trailer is driven correctly. A power supply of the tow vehicle can be used to drive the lighting of the trailer.

Contactless sensors, acting on the magnetic field of a current-carrying conductor, have already been disclosed, but have been found to be difficult and expensive to produce in practice, mainly due to the small DC currents to be detected, also referred to as direct currents, due to which the magnetic field is very weak compared to various external interferences. In particular when used in vehicles, this leads to sensors which have to undergo complicated calibrations, are expensive and are large and, in this case, cause problems with regard to wire lengths and limited installation space in which these sensors have to be fitted.

### Summary of the invention

It is an object of the invention to provide a device for detecting a current which improves at least one of said points.

This object is achieved by means of a device according to Claim 1. Preferred embodiments are described in the dependent claims.

Such a device for detecting a current in a conductor comprises a through-opening for the conductor and at least one magnetic field sensor. By means of the at least one magnetic field sensor, the magnetic field may be detected, that is caused by a current in the conductor. A sensor which is able to detect magnetic fields may have several sensor elements. The presence of the field, the size of the field or a change in the size of the field can be detected or measured by the sensor.

According to the invention, the device comprises a housing in which a yoke is fitted which is designed to accommodate the conductor, for example a wire or a cable, between the yoke and the sensor, so that the conductor is at least partially surrounded by the yoke and the sensor. The yoke conducts a flux and as a result of surrounding the conductor and, therefore, the magnetic field caused by the current to be detected in the conductor produces a coupled magnetic circuit with the sensor, as a result of which the magnetic field can be readily detected by the sensor. The combination of the sensor and the yoke according to the invention is self-screening against interference fields. The yoke is a deformable element, for example an elastically deformable element.

In an embodiment, the yoke can be adjusted to the size of the conductor in order to partially surround the conductor which is accommodated in the through-opening. This makes a tighter surrounding of the conductor possible with a larger coupling and thus a larger accuracy in the detection.

In an embodiment, the adjustability of the yoke allows the yoke to always surround the conductor. The surrounding of the conductor by the yoke results in the adjusting of the yoke to the size of the conductor. The adjustability of the yoke may be achieved for example by a mechanical construction.

In an embodiment, the yoke comprises a deformable material. Due to the deformability of the yoke, the surrounding function of the yoke can be optimized for conductors of different sizes. As a result, a single device can be obtained which can surround different conductors, for example wires of different diameters, in a simple manner. The currently proposed device for detecting a current can be used universally for many applications in which a sensitive, contactless and/or removable current sensor can be advantageous.

The shape of the yoke adjusts itself to the thickness of the conductor. In an initial position without deformation as a result of the surrounding of a conductor, the yoke may have a first shape, for example a flat shape. A surrounding of a conductor results in deformation of the yoke, adjusted to the size and/or the shape of the conductor.

The yoke may assume, in particular, a U-shaped cross section in order to partially surround a conductor, in particular a wire-shaped conductor. The conductor can be accommodated in the space of the U-shape. In the opening between the ends of U-shape, one or more sensors may be placed.

In an embodiment, the yoke is formed by a foil. A foil made of flexible, thin foil material can easily be deformed and thus be adjusted to the size and/or the shape of the conductor, as a result of which the yoke can adjoin the conductor tightly and can surround it. An advantage of the use of a foil compared to a piece of tin, iron or ferrite is that a foil can freely adjust its shape and can thus overcome incorrect alignments, for example due to tolerances. There is also little risk of breaking as occurs with ferrite cores, for example. Also in terms of manufacture of the sensor, a foil has advantages. A foil can easily be introduced into a housing and can be secured in the housing without specific fastening and does not have to undergo any further treatments beside being cut to size.

In an embodiment, the foil is thinner than 1 mm, for example the foil has a thickness of 0.1 mm. The fact that the section of the magnetic yoke is small due to the fact that the foil is thin, is no disadvantage, as the magnetic fields to be detected are caused by relatively small DC currents and are also therefore so small that no saturation or other negative effects can occur under these circumstances.

A deformable yoke, in particular an elastically deformable yoke, allows that the shape of the yoke adjusts itself to the shape of the conductor and that the yoke can be arranged near the sensor in a simple manner in order to realise a magnetic coupling with the sensor, more particularly in order to be arranged near the flux concentrators of the sensor. This allows a magnetic circuit to be obtained by the yoke and the sensor in a simple manner. In this case, the yoke short-circuits the magnetic interference fields and/or external magnetic fields across the sensor. Only the magnetic fields generated by a current inside the magnetic circuit, formed by the yoke and the sensor provided with flux concentrators, are in this case detected by the sensor.

In an embodiment, the foil material is an amorphous cobalt alloy. An amorphous cobalt alloy has a high magnetic permeability. In addition, this material has both an extremely low remanence and magnetostriction. Because of the low remanence this material is very suitable for detecting small currents without hysteresis effect and because of the low magnetostriction the material is pliable without loss of magnetic and/or mechanical properties, so that it can be used repeatedly. However, this type of material also has the property that it is magnetically very soft, but mechanically relatively hard. However, the material is specifically available in foil form.

In an embodiment, the foil material is Vitrovac 6025X by Vacuumschmelze. In another embodiment, the foil material is Metglas Alloy 2705M by Metglas. These foil materials make the pre-deformation and/or the thermal tempering of the used magnetic yoke superfluous. These foil materials are more advantageous in comparison with, for example, nickel-based alloys such as Mumetal or Permalloy, which in each case require a thermal tempering cycle after deformation.

In an embodiment, the yoke is kept under pretension. A suitable pretensioner can be used to keep the yoke in the housing. In an embodiment, the yoke itself has elastic properties. Due to the pretension or the elastic properties, the definite shape of the yoke adjusts itself to the size and/or shape of the conductor. As a result thereof, the optimum coupling is realised each time with the sensor and for each size and/or shape of the conductor a good surrounding is achieved. On the other hand, the pretension and/or the elasticity can return the yoke to its initial shape and/or its position after use or before use.

In an embodiment, the housing is formed by two housing parts which can be connected to one another, wherein the through-opening is formed between the two housing parts. In this case, the magnetic field sensor is fitted in the first housing part and the yoke is fitted in the second housing part. The housing parts may be synthetic housing parts. The yoke and the conductor are held in a specific position with respect to one another by means of the housing parts. The conductor is accommodated between the housing parts and thus surrounded by the yoke.

According to an embodiment, the yoke is brought into its position of use and shape of use during and by mounting the housing parts around the conductor.

The solution proposed here is a simple, compact and low-cost solution which is simple to produce, easy to install and requires no additional calibration.

In an embodiment, the housing parts are clamping parts. A tensioning element can tension the housing parts with respect to one another. In an embodiment, the housing parts are hingedly connected to one another.

In an embodiment, the through-opening comprises a U-shaped groove formed in the second housing part, wherein the yoke is shaped like a foil which is fitted over an open side of the groove. The edges of the groove ensure a connection of the yoke on or near the conductor and can also ensure a connection on the sensor. The edges form stops on which the foil can rest and along which the foil can be tensioned and guided.

In an embodiment, the sensor is mounted on a printed circuit board and the printed circuit board is mounted in the first housing part. This leads to a simple assembly of the device.

In an embodiment, ends of the yoke extend on either side of the through-opening. In particular, viewed in cross section, a U-shaped section is formed in the foil material. This U-shaped section surrounds the conductor. The remaining parts of the foil, on either side of the U-shaped section, protrude. The protruding parts realise an additional screening function against external interference fields.

In an embodiment, the sensor is placed in or near the opening of the U-shaped section of the yoke. In an embodiment, the sensor is then provided with an additional screening on the side of the sensor facing away from the yoke. As a result thereof, a further improved magnetic screening is obtained, which allows to detect the signal in the conductor better and/or make an extensive calibration superfluous.

In an embodiment, the sensor is an IMC-type Hall effect sensor. The term "IMC" means "Integrated Magnetic Conductor" or "integrated magnetic conductor", in other words with integrated flux concentrators.

In an embodiment, the sensor is designed as an integrated circuit comprising one or more sensor elements.

In an embodiment, the sensor comprises flux concentrators. Due to the required high sensitivity, sensitive Hall sensors with so-called built-in flux concentrators can be used. It is clear that such a sensor can be mounted in different ways.

In an embodiment, the yoke is located on the sensor in position of use, in particular on flux concentrators of the sensor. The yoke and the flux concentrators may produce a coupled magnetic circuit, as a result of which the device becomes more sensitive in order to detect a current in the conductor.

According to another aspect of the invention, a vehicle comprises a device according to the invention which is mounted on a conductor, for example on a conductor to a specific lighting. In this application, the advantages of the invention come into their own. Signals to the lighting of the vehicle, for example, to one of the rear lights of the vehicle, can be detected. On the basis of that detection, the lighting of a trailer can be driven. The power supply for the lighting of the trailer is in this case for example directly tapped off from a the power supply of the vehicle. This is preferably effected at the location of the battery of the vehicle, as a result of which the electronic system of the vehicle which drives the lighting of the vehicle does not have to be disturbed.

The device for detecting a current according to the invention is suitable for use in vehicles.

According to a further aspect of the invention, a method is provided for fitting the device according to the invention to a conductor. According to the invention, the fitting of the conductor in the through-opening causes a deformation of the yoke which is adjusted to the size and/or the shape of the conductor. This results in an improved detection of the magnetic field caused by the current in the conductor. The method comprises the accommodating of the conductor in a through-opening, wherein the yoke which is located near the through-opening on the conductor being deformed while the conductor is being accommodated in the through-opening, in order to partially surround the conductor.

### Brief description of the figures

Further features and advantages of the invention follow from the following description of the embodiments illustrated in the drawings, in which:
Fig. 1 shows an exploded view of a first embodiment of the invention;
Figs. 2 and 3 show views of the first embodiment of the invention;
Fig. 4 shows a partial view of the first embodiment from Fig. 2;
Fig. 5 shows a partial view of the first embodiment from Fig. 3;
Fig. 6 shows a transverse view of the first embodiment of the invention;
Fig. 7 shows a cross section in open position of the first embodiment from Fig. 2;
Fig. 8 shows a cross section similar to Fig. 7 of a variant embodiment;
Fig. 9 shows the embodiment from Fig. 8 in closed position;
Fig. 10 shows a view of yet another variant embodiment;
Fig. 11 shows a partially exploded view of the embodiment from Fig. 10.

### Detailed description of embodiments

The figures show embodiments according to the invention of a device for detecting a current in a conductor.

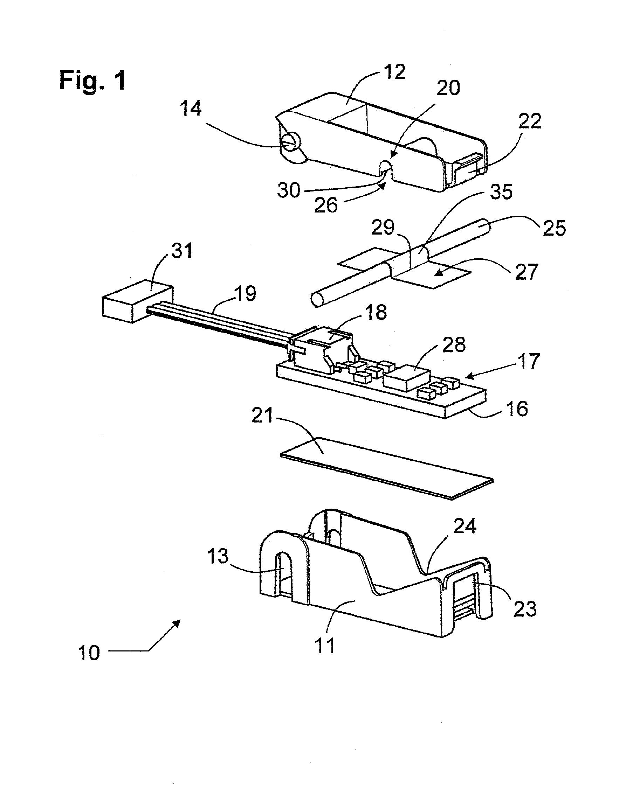

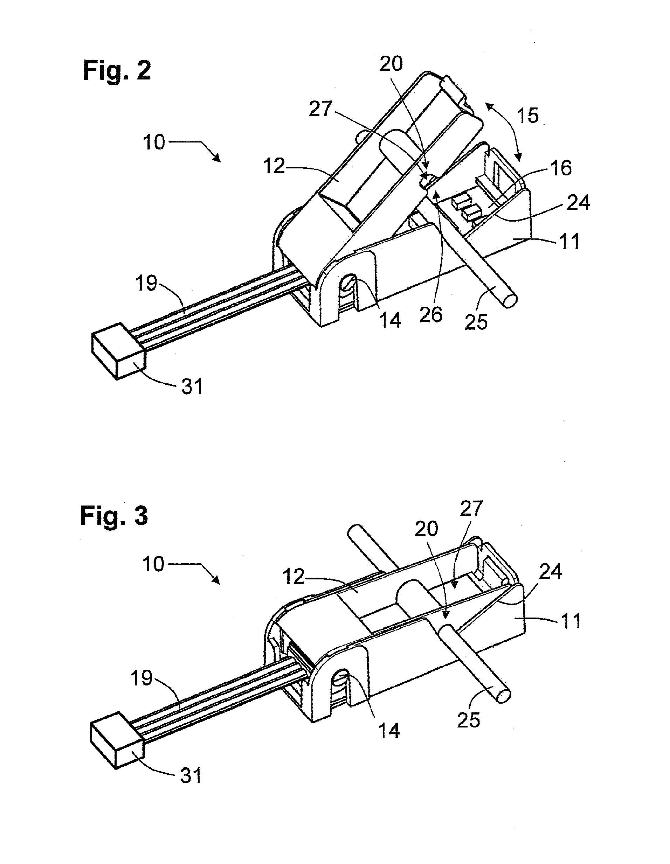

Fig. 1 shows an exploded view of a device 10 for detecting a current. In the illustrated embodiment, this device 10 comprises two housing parts 11, 12, for example plastic housing parts obtained by injection-moulding. The first housing part 11 comprises a space 13 for accommodating therein a shaft 14, which shaft 14 forms part of the second housing part 12, so that a hinged coupling between the housing parts 11, 12 is obtained, which coupling allows both housing parts 11, 12 to move with respect to one another as indicated by arrow 15 in Fig. 2.

In the first housing part 11 a printed circuit board 16 can be mounted. In the illustrated embodiment, a magnetic field sensor 28 and other electronic components 17 are mounted on the printed circuit board 16. The sensor 28 and the electronic components 17 form an electronic circuit. A terminal 18 for wires 19 may also be placed on the printed circuit board 16, which terminal 18 may be connected to the electronic circuit 31. Electrical signals can be transmitted from and to the electronic circuit 31 via the wires 19.

The printed circuit board 16 may be mounted in the first housing part 11, for example clamped between the housing parts 11 and 12. Other ways of mounting are possible.

The sensor 28 is designed as an integrated electronic circuit and is fitted on the printed circuit board 16, wherein the electronic components 17 for power supply and signal conditioning may be provided, as well as a terminal 18 for an electronic circuit 31 which furthermore acts as a measuring circuit.

According to an embodiment, an additional screening 21 is provided on the bottom side of the sensor 28, for example a plate-shaped screening which is arranged underneath the printed circuit board 16.

The use of a printed circuit board 16 with electronic components 17 and a sensor 28 designed as an integrated electronic circuit results in a reduction of the manufacturing costs of the device according to the invention.

The second housing part 12 has a resilient lip 22 which can cooperate with space 23 in the first housing part 11. In this way, the housing parts 11, 12 can be mutually held together in the position of use from Fig. 3. In this case, the housing parts 11, 12 form clamping parts.

The second housing part 12 has a U-shaped through-opening 20 which is directed in the position of use in the longitudinal direction of the conductor 25. In the position of use, the open side 26 of the through-opening 20 is located on the side facing the first housing part 11. The first housing part 11 has an edge 24.

A conductor 25 can be accommodated in the through-opening 20. In this embodiment, the conductor 25 is a wire-shaped conductor 25. In this case, the conductor 25 also bears against the edge 24. In the position of use from Fig. 3, the conductor 25 can be accommodated between the two housing parts 11, 12 in the through-opening 20 which is intended therefor. In this case, the conductor 25, in the position of use, then bears against the sensor 28.

The device 10 comprises a through-opening 20 which is formed by a groove through which the conductor 25 is passed in order to detect a current in that conductor 25.

A magnetic yoke 27 surrounds the conductor 25 at least partially in the position of use, illustrated in Fig. 1 and Fig. 3, and consists of a foil material. The yoke 27 bears directly against the conductor 25 and is adjustable, inter alia, with respect to the size and the shape of the conductor 25.

In this embodiment, the yoke 27, in its initial position, is at the location of the open side 26 of the through-opening 20, as can be seen in Fig. 2. By closing the housing parts 11, 12, the yoke 27 adjusts itself to the shape of the conductor 25.

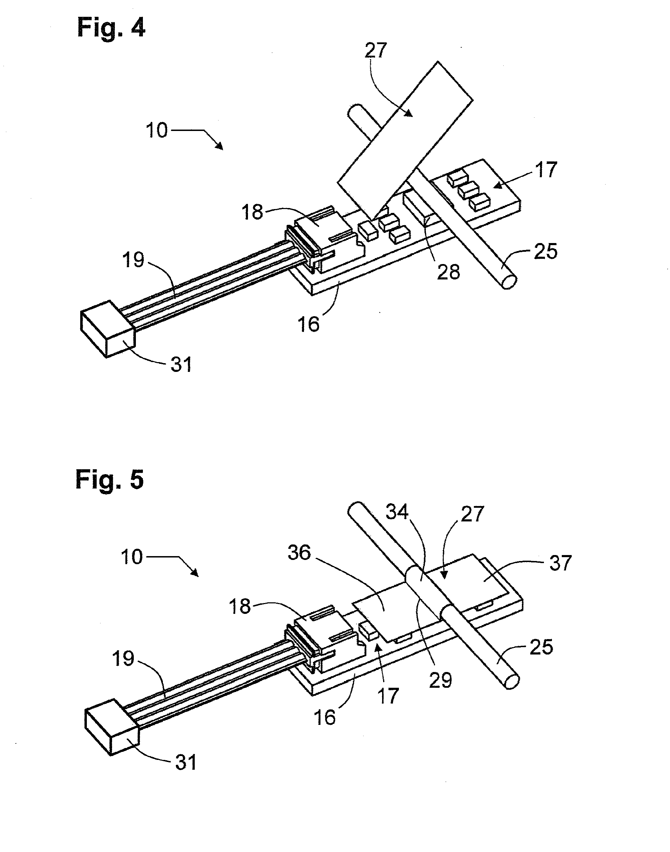

The conductor 25 deforms the yoke 27. Due to the surrounding of a conductor 25 with a round cross section, the yoke 27 acquires a U-shaped section 34. The yoke 27 may assume its definite shape during closing the device 10 on the conductor 25. The yoke 27 illustrated in Figs. 1 and 5 is in this position.

Despite the fact that the size of the conductor 25 influences the shape of the yoke 27, it is ensured that a minimal air gap is present between the yoke 27 and the sensor 28.

In the illustrated embodiment, the yoke 27 has elastic properties, as a result of which the yoke 27 is arranged around the conductor 25 and against the sensor 28 when it surrounds a conductor 25. When the housing parts 11, 12 move from the closed position to the open position according to arrow 15, the yoke 27 is removed from the conductor 25 and, due to its elastic properties, again assumes a shape as illustrated in Figs. 2 and 4.

Although thin conductors generally carry small currents, the coupling to the sensor 28 will be better with a thin conductor and a more reliable detection will be obtained than with thick conductors having large currents.

In this embodiment, the yoke 27 is deformable and can thus lie tightly around conductors 25 of different sizes and/or shape. As a result thereof, the device 10 can be used universally. Moreover, due to the tight surrounding, the sensitivity of various conductor sections is maximized.

Figs. 4 and 5 show the same embodiment and views as Figs. 2 and 3, respectively, wherein the housing parts 11, 12 are omitted. The yoke 27 surrounds the conductor 25. The edge 29 is the result of the stop function of the edges 30 of the through-opening 20 illustrated in Fig. 1. In position of use, the edges 29 of the U-shaped section 34 of the yoke 27 bear against the edges 30 of the through-opening 20, which edges 30 form fixed mechanical stops.

As illustrated in Fig. 5, parts 36, 37 of the yoke 27 protrude on either side of the U-shaped section 34 of the yoke 27. These protruding parts 36, 37 realise a screening function for external interference fields. This device 10 reduces the sensitivity to external fields generated by, for example, earth magnetism or by neighbouring current-carrying conductors. As a result thereof, the reliability of the detection is increased.

It is clear that a simple, quick and reclosable mounting of the device 10 on the conductor 25 is made possible. The conductor 25 does not have to be disconnected or interrupted. The housing parts 11, 12 are compact and the device 10 can be connected on short conductor sections which are free. The conductor 25, in particular a screening sheath of the conductor 25, such as for example a cable sheath, is not damaged in this case.

A device 10 according to the invention, inter alia, has the following properties. The device 10 has a high sensitivity and allows to detect low DC currents, for example currents lower than 1 Ampere. The device 10 has a high reliability. As a result, the device 10 can be used in a system for lighting and signalisation for vehicles, such as vehicles provided with a trailer.

The device 10 also makes compactness of installation possible and is applicable in a position where the individual current-carrying conductors are available independently and with conductors which are only a few centimetres in length.

The device 10 is intended to be used to detect the current by a conductor 25 of a vehicle. The sensor 28 may be fitted to that conductor 25 and is in the first place intended to drive, for example, the lighting of a trailer. This sensitive contactless device 10 makes it readily possible to detect small currents without being influenced substantially by interference and without damaging the electrical conductor 25.

The device 10 also allows a simple mounting, as disassembly of the original cabling can be avoided and also overly complicated calibration procedures can be avoided, which do not improve the reliability of systems. Due to the higher sensitivity to the current to be detected, a reliable, simple and calibration-free mounting becomes possible.

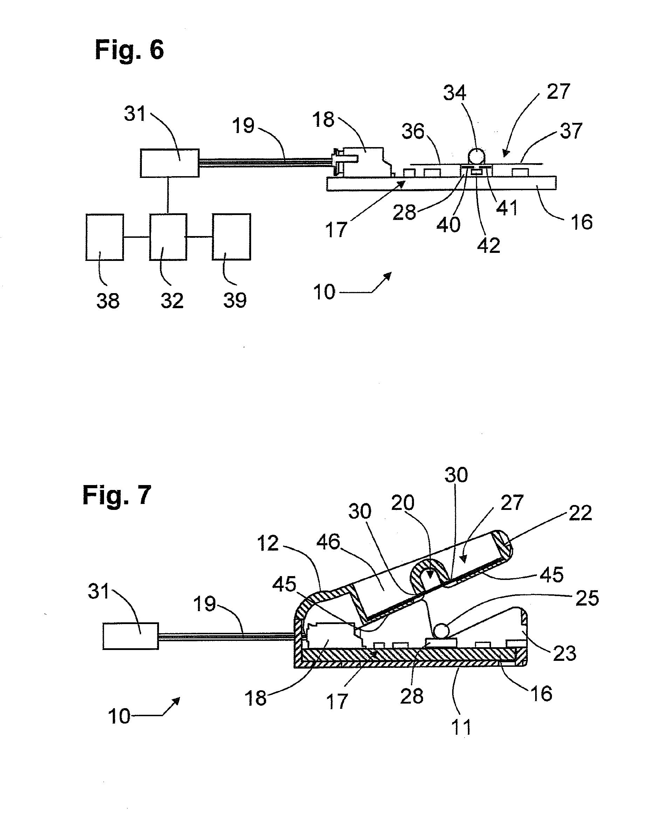

Fig. 6 shows a transverse view of a section of the device 10 from Fig. 1 in a position of use similar to that in Fig. 5. The sensor 28 which is fitted on the printed circuit board 16 comprises flux concentrators 40, 41 and a sensor element 42. These flux concentrators 40, 41 adjoin the yoke 27, more particularly on the protruding parts 36, 37 of the yoke 27. The sensor 28 comprises a schematically indicated magnetic field sensor element 42, in particular a Hall sensor element which is located between the flux concentrators 40, 41 and which is connected via the electronic components 17 of the printed circuit board 16 and the wires 19 to an electronic circuit 31 which forms a measuring device and which cooperates with a switching device 32 for causing a current to flow from a power supply 38, for example a battery of a vehicle, to a lighting 39, for example a light of a trailer.

As illustrated in Fig. 6, the yoke 27, in the position of use, not only bears against the conductor 25, but also against the sensor 28. A magnetic coupling is achieved for the magnetic field caused by the current through the conductor 25, which magnetic field can be detected with the sensor element 42. Due to the yoke 27, the magnetic coupling to the sensor element 42 is significantly increased and this because the yoke 27 according to the invention can be adjusted to the size and/or the shape of the conductor 25.

Fig. 7 shows an embodiment according to the invention wherein the yoke 27 which is fitted in the second housing part 12 is held between edges 30 of the through-opening 20 and the bottom surfaces 45 of the second housing part 12 which are fitted between the side walls 46 of the second housing part 12. The bottom surfaces 45 allow that the yoke 27 moves in its longitudinal direction in the housing part 12 when closing the housing parts 11 and 12.

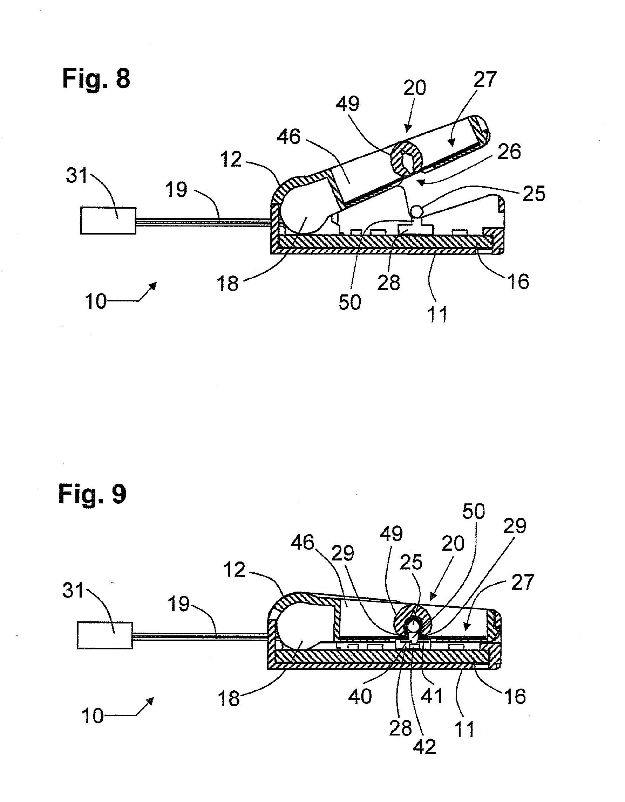

Figs. 8 and 9 show an example of a second embodiment of a device 10 according to the invention. The through-opening 20 is in this case formed by a substantially U-shaped surrounding element 49 which can be fitted around a conductor 25. At the location of the sensor 28, a collar 50 is provided which allows that the legs of the surrounding element 49 are located at least at a certain distance from each other near the open side 26. The surrounding element 49 and/or the collar 50 allow that the yoke 27 surrounds the conductor 25 in closed position of the device 10 and that the edges 29 of the yoke 27 are located near a flux concentrator 40 or 41. The surrounding element 49 is designed to be elastically deformable and resilient, so that a good surrounding of the conductor 25 is obtained and the edges 29 of the yoke 27 come to lie as closely as possible to the flux concentrators 40 and 41. In this case, a magnetic circuit is formed by means of the yoke 27 and the flux concentrators 40 and 41, wherein the flux in this magnetic circuit which is generated by a current in the conductor 25 can be measured by the sensor element 42 of the sensor 28.

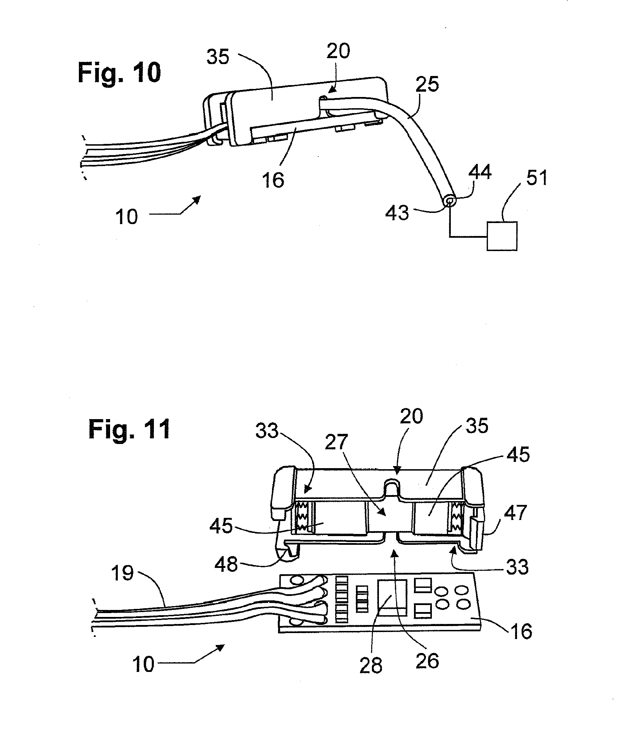

Figs. 10 and 11 show an example of a third embodiment of a device 10 according to the invention. The printed circuit board 16 has a sensor 28 in which a magnetic field sensor element is included. A housing part 35 is provided with a yoke 27 made from an amorphous cobalt alloy. The housing part 35 has a through-opening 20. The through-opening 20 is formed by a groove through which a conductor 25 can be passed. In the position of use of the device 10, the printed circuit board 16 is clamped by the housing part 35 and the sensor 28 forces the conductor 25 against the yoke 27, which yoke 27 will deform and will at least partially surround the conductor 25, similar to the shape of yoke 27 from Fig. 6. In this embodiment, the printed circuit board 16 acts as the first housing part 11 from Fig. 1, while the housing part 35 acts as the second housing part 12 from Fig. 2.

The conductor 25 is, for example, a conductor for conducting current to a lighting 51, such as a rear light of a vehicle. A device 10 according to the invention is placed on that conductor 25. The device 10 can be fitted to the conductor 25 and removed from the conductor 25 without damaging the conductor 25. As indicated in Fig. 10, the conductor 25 consists of a known electrical wire formed by a metal wire 43 which is surrounded by an insulating material 44. The housing part 35 comprises a lip 47 and stop elements 48 to fit the housing part 35 on the printed circuit board 16.

Fig. 11 also shows how the yoke 27 is fitted in the housing part 35 under pretension by means of a schematically illustrated pretensioner 33. By building-in a pretensioner 33, for example comprising resilient elements, in the housing part 35, the coupling to the sensor 28 can be improved, depending on the shape and/or the size of the conductor 25. The tensioned yoke 27 is in open position near the open side 26 of the through-opening 20. This allows the yoke 27, in position of use, to be at least partially tensioned around the conductor 25 accommodated in the through-opening 20. This also allows to provide a very thin foil material as yoke 27.

Since the conductor 25 is partially surrounded by the yoke 27 and partially by the magnetic field sensor 28, the conductor 25 can be at least partially and preferably substantially completely surrounded by the yoke 27 together with the sensor 28 and the magnetic field which is caused by a current in the conductor 25 can be detected easily and accurately by the sensor 28.

The device for detecting a current according to the invention is obviously not limited to the embodiments which have been described by way of example and illustrated in the figures. The device for detecting a current may also, within the claims, be designed according to variant embodiments, shapes and sizes. In addition, combinations of the illustrated embodiments are possible which come under the claims.

## Claims

1. Device for detecting a current in a conductor (25), wherein the device (10) comprises a magnetic field sensor (28), **characterized in that** the device (10) comprises a deformable yoke (27), which yoke (27) can be fitted around the conductor (25) in order to accommodate the conductor (25) between the yoke (27) and the sensor (28), wherein the yoke (27) is deformed by the conductor (25) in position of use in such a manner that the conductor (25) is at least partially surrounded by the yoke (27) and the sensor (28).

2. Device according to Claim 1, **characterized in that** the yoke (27) can be adjusted to the size and/or the shape of the conductor (25) in order to partially surround a conductor (25) which is accommodated in a through-opening (20).

3. Device according to Claim 1 or 2, **characterized in that** the yoke (27) comprises a deformable material.

4. Device according to Claim 3, **characterized in that** the deformable material is a foil material.

5. Device according to Claim 4, **characterized in that** the foil material is an amorphous cobalt alloy.

6. Device according to any one of Claims 2 to 5, **characterized in that** the through-opening (20) is arranged in a housing part (12, 35) and **in that** the yoke (27) is arranged over an open side (26) of the through-opening (20).

7. Device according to any one of Claims 2 to 6, **characterized in that** the through-opening (20) is formed between two housing parts (11, 12) which can be coupled together, wherein the magnetic field sensor (28) is mounted in the first housing part (11) and the yoke (27) is mounted in the second housing part (12).

8. Device according to Claim 6 or 7, **characterized in that** the housing parts (11, 12) are hingedly connected.

9. Device according to Claim 7 or 8, **characterized in that** the sensor (28) is mounted on a printed circuit board (16) and the printed circuit board (16) is mounted in the first housing part (11).

10. Device according to any one of Claims 1 to 9, **characterized in that** the yoke (27) comprises parts (36, 37) which, in position of use, extend on either side of the through-opening (20) in order to realise a screening function against interference fields.

11. Device according to any one of Claims 1 to 10, **characterized in that** the sensor (28) is provided with an additional screening (21) on the side of the sensor (28) facing away from the yoke (27).

12. Device according to any one of Claims 1 to 11, **characterized in that** the yoke (27) is connected to a housing part (35) under pretension.

13. Device according to any one of Claims 1 to 12, **characterized in that** the yoke (27) is elastically deformable.

14. Device according to any one of Claims 1 to 13, **characterized in that** the yoke (27) is deformed by the conductor (25) during fitting of the conductor (25) in such a manner that the conductor (25) is at least partially surrounded by the yoke (27) and the sensor (28).

15. Vehicle comprising a conductor (25) for conducting a current to a lighting (51) of the vehicle, **characterized in that** the vehicle comprises a device (10) according to any one of Claims 1 to 13 which is mounted on the conductor (25).

16. Method for arranging a device (10) according to any one of Claims 1 to 14 to a conductor (25), **characterized in that** the method comprises accommodating the conductor (25) in a through-opening (20) of the device (10), wherein the yoke (27) deforms on the conductor (25) during accommodating the conductor (25), in order to partially surround the conductor (25).
